**Europäisches Patentamt**

**European Patent Office**

**Office européen des brevets**

(11) Veröffentlichungsnummer: **0 071 608**
**B1**

(12) # EUROPÄISCHE PATENTSCHRIFT

(45) Veröffentlichungstag der Patentschrift:
**23.04.86**

(51) Int. Cl.⁴: **H 03 K 4/50**

(21) Anmeldenummer: **81903012.3**

(22) Anmeldetag: **06.11.81**

(86) Internationale Anmeldenummer:
**PCT/DE 81/00193**

(87) Internationale Veröffentlichungsnummer:
**WO 82/02807 (19.08.82 Gazette 82/20)**

(54) **SÄGEZAHNSPANNUNGSGENERATOR.**

(30) Priorität: **13.02.81 DE 3105253**

(43) Veröffentlichungstag der Anmeldung:
**16.02.83 Patentblatt 83/7**

(45) Bekanntmachung des Hinweises auf die Patenterteilung:
**23.04.86 Patentblatt 86/17**

(84) Benannte Vertragsstaaten:
**DE FR GB SE**

(56) Entgegenhaltungen:
**EP - A - 0 013 298**
**FR - A - 2 444 970**

**Telecommunications and radio engineering, vol. 27, no. 4, April 1972, (Washington), Z.P. Vazhenina "Sawtooth voltage generator with correcting circuits", pages 120-122**

(73) Patentinhaber: **ROBERT BOSCH GMBH, Postfach 50, D-7000 Stuttgart 1 (DE)**

(72) Erfinder: **STEINMANN, Helmut, Höllhäuserweg 66, D-7570 Baden-Baden (DE)**

(74) Vertreter: **Röser, Peter, c/o Robert Bosch GmbH Robert-Bosch-Platz 1, D-7016 Gerlingen-Schillerhöhe (DE)**

ACTORUM AG

# Beschreibung

Die Erfindung betrifft einen Sägezahnspannungsgenerator nach der Gattung des Hauptanspruches, wie er insbesondere für die Verwendung als Takt- und Referenzspannungsgenerator einer elektronischen Kraftfahrzeug-Heizungsregelung vorteilhaft verwendbar ist. Ein solcher Sägezahnspannungsgenerator ist bereits vorgeschlagen worden, wobei die Ausgangsspannung an einem Kondensator abgegriffen wurde, der über einen ersten niederohmigen Widerstand aufladbar und über einen anderen, höherohmigen Widerstand mit grösserer Zeitkonstante entladbar war. So ergaben sich zwei RC-Glieder, wobei das C-Glied jeweils das gleiche, die R-Glieder jedoch unterschiedlich waren. Das erste RC-Glied bestimmt die Anstiegsflanke, das weitere RC-Glied die Abfallflanke der Sägezahnspannung. Dieser Sägezahnspannungsgenerator besass also aufgrund des niederohmigen Ladewiderstandes eine sehr steil ansteigende Flanke der Sägezahnspannung, so dass die Taktzeit nahezu ausschliesslich von der Zeitkonstanten des Entladekreises des Kondensators bestimmt war.

Aus der FR-A 2 444 970 ist eine Einrichtung einer Schwingungspaketsteuerung mit Regelung mittels eines statischen Wechselstrom-Stellgliedes bekannt, welche einen Sägezahngenerator als Taktfrequenzgeber enthält. Die Anstiegsflanke und die Abfallflanke des Sägezahns sind verschieden, beide verlaufen praktisch geradlinig.

Weiterhin ist aus Telecommunications and radio engineering, Vol. 27 Nr. 4 April 1972, Seite 120 bis 122 ein Sägezahnspannungsgenerator bekannt, bei dem zwei verschiedene Kondensatoren über getrennte Kreise geladen und über einem gemeinsamen Kreis entladen werden. Bei dieser Anordnung bildet ein RC-Glied einen Korrektur-Stromkreis für das zweite RC-Glied.

## Vorteile der Erfindung

Der erfindungsgemässe Sägezahnspannungsgenerator mit den kennzeichnenden Merkmalen des Hauptanspruches hat gegenüber den bekannten Ausführungen den Vorteil, dass die Kurvenform der Abfallflanke unabhängig von der Taktzeiteinstellung eingestellt werden kann. Diese Kurvenform ist in weiten Grenzen in Richtung schärferer Krümmung veränderbar, wobei die Dimensionierung der Schaltung völlig unkritisch ist. Es ergibt sich ein stetiger Kurvenverlauf ohne Knickstellen mit einer weitgehend frei wählbaren Nichtlinearität der Abfallflanke, welche zur Erzielung besonderer Effekte bei einer nachgeschalteten Regelungsanordnung benutzt wird. Der erfindungsgemässe Sägezahnspannungsgenerator soll inbesondere verwendet werden bei einer elektronischen Heizungsregelung als Taktgenerator und Referenzspannungserzeuger für die Impulsbreitenmodulation des Ausgangssignals. Bei den hierfür bisher bekannten Schaltungen von Sägezahnspannungsgeneratoren war es nicht möglich, die Kurvenform der Sägezahnspannung nennenswert zu beeinflussen, was aber notwendig ist bei der Anwendung in einer elektronischen Heizungsregelung, um durch Erzeugung einer geeigneten Nichtlinearität der Abfallflanke der Sägezahnspannung die Nichtlinearität des verwendeten Stellgliedes zu kompensieren. Im genannten Anwendungsfall besteht die zu kompensierende Nichtlinearität in der Charakteristik des Wärmetauschers und des Heizwasserventils.

Durch die in den Unteransprüchen aufgeführten Massnahmen sind vorteilhafte Weiterbildungen und Verbesserungen des im Hauptanspruch angegebenen Sägezahnspannungsgenerators möglich. Besonders vorteilhaft zum Aufbau einer betriebssicheren einfachen Schaltung ist es dabei, wenn der erste Kondensator mit dem weiteren Kondensator in an sich bekannter Weise im wesentlichen über den gleichen niederohmigen Ladekreis auf etwa die gleiche Spannung aufladbar ist, dann jedoch über einen separaten Entladekreis mit einer weitgehend frei wählbaren Zeitkonstante auf eine höhere Spannung entladen wird. Zweckmässigerweise wird die geforderte Ausgangsspannung mittels eines als Komparator arbeitenden Operationsverstärkers erzeugt, dessen nicht invertierender Eingang am Verbindungspunkt eines an eine Gleichspannungsversorgungseinrichtung angeschlossenen Referenzspannungsteilers liegt und dessen Ausgang einerseits über einen ohmschen Widerstand auf den nicht invertierenden Eingang mitgekoppelt und über ein Verzögerungsglied gegengekoppelt ist. Eine derartige, an sich ebenfalls bekannte Ausgestaltung der erfindungsgemässen Schaltungsanordnung erlaubt es, mit wenigen Bauteilen eine betriebssichere und einfache Schaltungsanordnung aufzubauen. Dabei wird der erste Kondensator im Bereich der Abfallflanke des Sägezahns in Richtung des am Ausgang des Operationsverstärkers anliegenden Massepotentials entladen, während für den weiteren Kondensator als Entladespannung eine Spannung grösser als Null vorgegeben ist. Vorteilhafterweise wird die Anordnung dabei so getroffen, dass sich der weitere Kondensator während der Entladezeit auf die Referenzspannung der unteren Schaltschwelle des Operationsverstärkers entlädt.

## Zeichnung

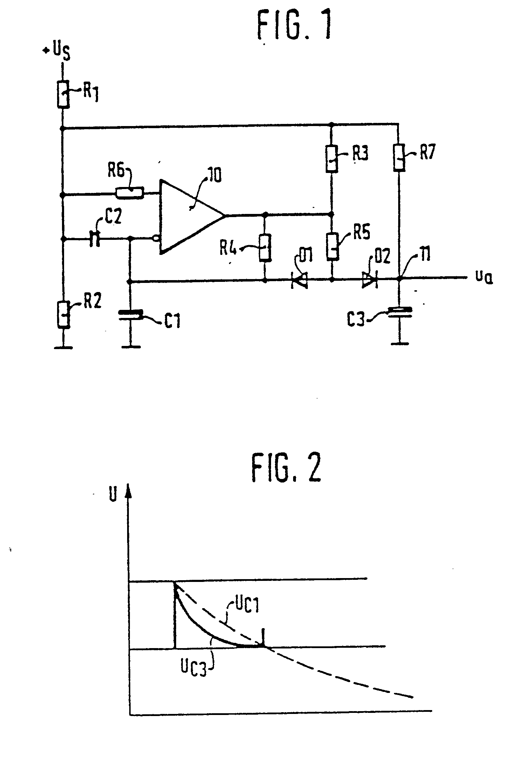

Ein Ausführungsbeispiel der Erfindung ist in der Zeichnung dargestellt und anhand der nachfolgenden Beschreibung näher erläutert. Es zeigen Figur 1 eine Schaltungsanordnung in einfacher Schaltungsausführung und Figur 2 ein zugehöriges Spannungsdiagramm.

## Beschreibung des Ausführungsbeispieles

In Figur 1 ist mit $U_s$ eine Gleichspannungsversorgungseinrichtung bezeichnet, wobei es sich vorzugsweise um das Bordnetz eines Kraftfahrzeuges handelt. Die Gleichspannung liegt an einem Anschluss eines Widerstandes R1, dessen anderer Anschluss mit dem zweiten Spannungsteilerwiderstand R2 und dieser wiederum mit

2

Masse verbunden ist. An die Verbindungsleitung zwischen den Widerständen R1 und R2 ist über einen Widerstand R6 der nicht invertierende Eingang und über einen Kondensator C2 der invertierende Eingang eines Operationsverstärkers 10 angeschlossen. Der Ausgang des Operationsverstärkers 10 ist einerseits über einen Widerstand R3 auf den Referenzspannungsteiler R1, R2 mitgekoppelt und andererseits über einen Widerstand R4 und eine hierzu parallelliegende Reihenschaltung aus einem Widerstand R5 und einer Diode D1 auf seinen invertierenden Eingang gegengekoppelt. Der invertierende Eingang des Operationsverstärkers 10 liegt weiterhin über einen Kondensator C1 an Masse.

An den Verbindungspunkt des Widerstandes R5 und der Anode der Diode D1 ist weiterhin die Anode einer Diode D2 angeschlossen, deren Kathode an einem Verbindungspunkt 11 liegt. An diesem Verbindungspunkt 11 wird die sägezahnförmige Ausgangsspannung $U_a$ abgegriffen. Ferner sind an diesen Verbindungspunkt 11 der eine Belag eines Kondensators C3, dessen anderer Belag auf Massepotential liegt, sowie das eine Ende eines weiteren Widerstandes R7 angeschlossen, dessen anderes Ende ebenfalls an der Verbindungsleitung zwischen den Spannungsteilerwiderständen R1 und R2 liegt.

Der Kondensator C2 am invertierenden Eingang des Operationsverstärkers 10 dient zur Unterdrückung von Störspannungen, der Widerstand R6 am nicht invertierenden Eingang des Operationsverstärkers 10 wirkt als Schutz vor Spannungsspitzen.

Die beschriebene Schaltungsanordnung arbeitet folgendermassen:

Beim Einschalten der Gleichspannungsversorgungseinrichtung $U_s$ gelangt positives Potential auf den nicht invertierenden Eingang des Operationsverstärkers 10, der Kondensator C1 ist ungeladen. Wegen der anfallenden Spannungsdifferenz zwischen den beiden Eingängen des Operationsverstärkers liegt an dessen Ausgang die maximale Ausgangsspannung, die etwa der positiven Versorgungsspannung entspricht, so dass der Kondensator C1 über die Widerstände R4 und R5 aufgeladen wird. Der Widerstand R5 ist dabei wesentlich niederohmiger als der Widerstand R4, so dass über R4 praktisch kein Ladestrom in den Kondensator C1 fliesst. Gleichzeitig fliesst ein Ladestrom über den gleichen Widerstand R5 in praktisch gleicher Höhe über die Diode D2 in den Kondensator C3. Dieser wird so in gleicher Zeit auf die gleiche Spannung aufgeladen wie der Kondensator C1, was aus dem Diagramm in Figur 2 im Bereich der Anstiegsflanke zu ersehen ist.

Nach sehr kurzer Aufladezeit ist die Differenz an den beiden Eingängen des Operationsverstärkers so gering geworden, dass die obere Schaltschwelle erreicht ist. Der Ausgang des Operationsverstärkers springt auf den minimalen Ausgangsspannungswert, der etwa Massepotential entspricht. Ab diesem Zeitpunkt wird der Kondensator C1 über den Widerstand R4 gegen Masse entladen, der Kondensator C3 entlädt sich über den Widerstand R7 in Richtung einer Spannung, welche grösser als 0 Volt ist.

Der Widerstand R3 wirkt als Mitkopplungswiderstand auf den Referenzspannungsteiler R1, R2. Die Widerstände R4 und R5 sowie die Diode D1 und der Kondensator C1 bilden die Gegenkopplung des Operationsverstärkers 10. Da die Aufladung des Kondensators C1 über den sehr niederohmigen Widerstand R5 und die Diode D1 besonders rasch erfolgt, wie aus der steil ansteigenden Flanke der Sägezahnspannung in Figur 2 ersichtlich ist, wird die Taktzeit des Generators nahezu ausschliesslich von der Entladezeitkonstante aus den Widerständen R4 und C1 bestimmt.

Um eine in weiten Grenzen frei einstellbare Kurvenform der Abfallflanke der Sägezahnspannung zu erhalten, ist der Schaltungsanordnung das Netzwerk aus dem Widerstand R7, der Diode D2 und dem Kondensator C3 angefügt. Der Kondensator C3 wird über den niederohmigen Widerstand R5 und die Diode D2 während der Aufladezeit des Kodensators C1 auf nahezu die gleiche Spannung aufgeladen wie der Kondensator C1. Die beiden Spannungsspitzen in Figur 2 fallen also zusammen. Der über den Widerstand R7 fliessende Ladestrom des Kondensators C3 ist vernachlässigbar, ebenso der durch Fertigungstoleranzen bedingte geringfügige Unterschied zwischen den beiden gleichartigen Dioden D1 und D2. Während der Entladezeit des Kondensators C1 entlädt sich auch der weitere Kondensator C3, jedoch nicht wie der Kondensator C1 über den Widerstand R4 nach Massepotential am Ausgang des Operationsverstärkers, sondern über den Widerstand R7 auf eine Spannung grösser als 0 Volt, z.B. auf die Referenzspannung der unteren Schaltschwelle des Operationsverstärkers. Dabei besteht die Bedingung, dass diese untere Schaltschwelle, dargestellt durch die Widerstände R1, R2 und R3 ausreichend niederohmig ist oder dass sie gegebenenfalls über einen als Spannungsfolger arbeitenden, nicht dargestellten weiteren Operationsverstärker abgekoppelt ist gegenüber dem Entladewiderstand R7. Da die Entladezeitkonstante für die Anordnung aus dem Widerstand R7 und dem Kondensator C3 völlig unabhängig von der Zeitkonstante des die Taktzeit bestimmenden Gliedes aus dem Widerstand R4 und dem Kondensator C1 einstellbar ist, kann am Kondensator C3 eine Sägezahnspannung mit nahezu beliebiger spitzer Kurvenform oder schärferer Krümmung als am Kondensator C1 erzeugt werden. Die am Kondensator C1 abfallende Spannung ist in Figur 2 mit gestrichelten Linien angedeutet und zeigt deutlich den Unterschied in der Nichtlinearität der Kurven. Durch die erfindungsgemässe Schaltungsanordnung wird es möglich, die Kurvenform der Abfallflanke der Sägezahnspannung frei einstellbar zu machen, entsprechend der gewünschten Nichtlinearität zur Kompensation anderer Nichtlinearitäten einer Regelungsanordnung.

Schaltungsalternativen zum Operationsverstärker 10 können derart ausgebildet sein, dass der Verstärker mit diskreten Transistoren aufgebaut ist.

**Patentansprüche**

1. Sägezahnspannungsgenerator, insbesondere für die Verwendung als Takt- und Referenzspannungsgenerator einer elektronischen Kraftfahrzeug-Heizungsregelung, mit wenigstens einem RC-Glied mit unterschiedlicher Zeitkonstante für die Lade- und Entladephase, dadurch gekennzeichnet, dass für die Taktzeitfestlegung ein erstes RC-Glied (R4, C1) und für die Kurvenformbestimmung ein zweites RC-Glied (R7, C3) Verwendung findet, wobei die Kondensatoren (C1, C3) der RC-Glieder im wesentlichen über denselben niederohmigen Ladekreis (R5, D1, D2) auf etwa die gleiche Spannung aufladbar und über separate Entladekreise (R4, R7) entladbar sind, wobei die Entladezeitkonstante des zweiten RC-Gliedes (R7, C3) weitgehend frei wählbar ist und sein Kondensator (C3) auf eine andere, vorzugsweise höhere Spannung entladbar ist als die des Kondensators des ersten RC-Gliedes (R4, C1), derart, dass die Ausgangsspannung (Ua) eine steile Anstiegsflanke und eine nichtlineare, wesentlich flachere Abfallflanke besitzt.

2. Sägezahnspannungsgenerator nach Anspruch 1, dadurch gekennzeichnet, dass das die Kurvenform der Abfallflanke des Sägezahns bestimmende zweite RC-Glied (R7, C3) einen separaten Entladewiderstand (R7) und einen separaten Kondensator (C3) aufweist, an welchem die Ausgangsspannung (Ua, $U_c3$) abgreifbar ist und dass die beiden RC-Glieder (R4, C1; R7, C3) während ihrer Entladephase über Dioden (D2, D3) voneinander entkoppelt sind.

3. Sägezahnspannungsgenerator nach Anspruch 1 oder 2, dadurch gekennzeichnet, dass die Ausgangsspannung (Ua) mit einem als Komparator arbeitenden Operationsverstärker (10) erzeugt wird, dessen nicht invertierender Eingang am Verbindungspunkt eines an eine Gleichspannungsversorgungseinrichtung ($U_S$) angeschlossenen Referenzspannungsteilers (R1, R2) liegt und dessen Ausgang einerseits über einen ohmschen Widerstand (R3) auf den nicht invertierenden Eingang mitgekoppelt und über ein das erste RC-Glied (R4, C1) enthaltendes Verzögerungsglied (R4, R5, D1, C1) gegengekoppelt ist.

4. Sägezahnspannungsgenerator nach Anspruch 3, dadurch gekennzeichnet, dass sich der Kondensator (C3) des die Kurvenform bestimmenden zweiten RC-Gliedes während der Entladephase auf eine vorgegebene Referenzspannung, vorzugsweise auf die Referenzspannung der unteren Schaltschwelle des Operationsverstärkers (10) entlädt.

**Claims**

1. Sawtooth-voltage generator, particularly for use as clock and reference-voltage generator of an electronic motor vehicle heater control system, comprising at least one RC section having a different time constant for the charging and the discharging phase, characterised in that for determining the clock period, a first RC section (R4, C1) is used and for determining the shape of the curve, a second RC section (R7, C3) is used, in which arrangement the capacitors (C1, C3) of the RC sections can be essentially charged via the same low-resistance charging circuit (R5, D1, D2) to approximately the same voltage and can be discharged via separate discharging circuits (R4, R7), the discharging time constants of the second RC section (R7, C3) being largely freely selectable and its capacity (C3) being dischargeable to a different and preferably higher voltage than that of the capacitor of the first RC section (R4, C1), in such a manner that the output voltage (Ua) has a steep rising edge and a nonlinear, considerably flatter falling edge.

2. Sawtooth-voltage generator according to Claim 1, characterised in that the second RC section (R7, C3) determining the shape of the curve of the falling edge of the sawtooth is provided with a separate discharge resistor (R7) and a separate capacitor (C3), at which the output voltage (Ua, $U_c3$) can be tapped off and that the two RC sections (R4, C1; R7, C3) are decoupled from each other via diodes (D2, D3) during their discharging phase.

3. Sawtooth-voltage generator according to Claim 1 or 2, characterised in that the output voltage (Ua) is generated by means of an operational amplifier (10) which works as a comparator and the non-inverting input of which is located at the junction of a reference voltage divider (R1, R2) connected to a direct-voltage supply facility ($U_S$) and the output of which, on the one hand, is positively fed back via a resistive impedance (R3) to the non-inverting input and is negatively fed back via a delay section (R4, R5, D1, C1) containing the first RC section (R4, C1).

4. Sawtooth-voltage generator according to Claim 3, characterised in that the capacitor (C3) of the second RC section determining the shape of the curve discharges during the discharging phase to a predetermined reference voltage, preferably to the reference voltage of the lower switching threshold of the operational amplifier (10).

**Revendications**

1. Générateur de tension en dents de scie, notamment pour être utilisé comme générateur de synchronisation et de référence de tension d'une régulation électronique de chauffage de véhicule, avec au moins un organe RC avec des constantes de temps différentes pour les phases de charge et de décharge, générateur caractérisé en ' ce qu'un premier organe RC (R4, C1) est utilisé pour la fixation du temps de synchronisation et qu'un second organe RC (R7, C3) est utilisé pour la détermination de la forme des courbes, les condensateurs (C1, C3) des organes RC étant susceptibles essentiellement d'être chargés par l'intermédiaire du même circuit de charge à basse résistance ohmique (R5, D1, D2) à à peu près la même tension et étant susceptibles d'être déchargés par l'intermédiaire de circuits distincts de décharge (R4, R7), la constante de temps de décharge du second organe RC (R7, C3) étant, dans une large mesure, susceptible d'être choisie librement et son condensateur (C3) étant susceptible d'être déchargé sur une autre tension de préférence supérieure à celle du condensateur du premier organe RC (R4, C1), de sorte que la tension de sortie (Ua) comporte un flanc montant raide et un flanc descendant non linéaire essentiellement plus plat.

2. Générateur de tension en dents de scie selon la revendication 1, caractérisé en ce que le second organe RC (R7, C3) déterminant la forme de la courbe du flanc descendant de la dent de scie, comporte une résistance de décharge séparée (R7) et un condensateur séparé (C3), sur lequel peut être prélevée la tension de sortie (Ua, $U_c3$) et que les deux organes RC (R4, C1; R7, C3), pendant leur phase de décharge, sont découplés l'un de l'autre par l'intermédiaire de diodes (D2, D3).

3. Générateur de tension en dents de scie selon la revendication 1 ou 2, caractérisé en ce que la tension de sortie ($U_1$) est obtenue par un amplificateur opérationnel fonctionnant comme comparateur (10) dont l'entrée non inversée se situe au point de jonction d'un diviseur de tension de référence (R1, R2) raccordé à un dispositif d'alimentation en tension continue ($U_S$) et dont la sortie est, d'une part, couplée par l'intermédiaire d'une résistance ohmique (R3) sur l'entrée non inversée et contre-couplée par l'intermédiaire d'un organe de temporisation (R4, R5, D1, C1) comportant le premier organe RC (R4, C1).

4. Générateur de tension en dents de scie selon la revendication 3, caractérisé en ce que le condensateur (C3) du second organe RC déterminant la forme de courbe se décharge pendant la phase de décharge sur une tension de référence prédéfinie, de préférence sur la tension de référence du seuil inférieur de commutation de l'amplificateur opérationnel (10).

# FIG. 1

# FIG. 2